(19) Europäisches Patentamt
European Patent Office
Office européen des brevets

(11) **EP 2 175 554 B1**

(12) **FASCICULE DE BREVET EUROPEEN**

(45) Date de publication et mention
de la délivrance du brevet:
**12.03.2014 Bulletin 2014/11**

(51) Int Cl.:
***H03D 7/18*** *(2006.01)*

(21) Numéro de dépôt: **09164335.3**

(22) Date de dépôt: **01.07.2009**

(54) **Mélangeur heterodyne reconfigurable et procédés de configuration**

Rekonfigurierbarer Heterodynmischer und Konfigurationsverfahren

Reconfigurable heterodyne mixer and configuration methods

(84) Etats contractants désignés:
**AT BE BG CH CY CZ DE DK EE ES FI FR GB GR
HR HU IE IS IT LI LT LU LV MC MK MT NL NO PL
PT RO SE SI SK SM TR**

(30) Priorité: **04.07.2008 FR 0803813**

(43) Date de publication de la demande:
**14.04.2010 Bulletin 2010/15**

(73) Titulaire: **THALES
92200 Neuilly-sur-Seine (FR)**

(72) Inventeur: **Ulian, Patrice
31310, LATRAPE (FR)**

(74) Mandataire: **Esselin, Sophie et al
Marks & Clerk France
Conseils en Propriété Industrielle
Immeuble Visium
22, Avenue Aristide Briand
94117 Arcueil Cedex (FR)**

(56) Documents cités:
**US-A- 5 410 743      US-A- 5 950 119
US-A- 6 137 999      US-A1- 2003 031 273
US-A1- 2003 181 187    US-A1- 2004 002 323
US-A1- 2006 035 617**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

La présente invention concerne le domaine des mélangeurs hétérodynes pour des signaux électromagnétiques. Plus particulièrement l'invention se rapporte aux dispositifs permettant de réduire les signaux parasites en sortie d'un mélangeur hétérodyne.

Généralement un mélangeur hétérodyne comprend au moins un oscillateur local, noté OL, permettant de mélanger un signal d'entrée, noté RF, afin de générer un signal utile sur une fréquence intermédiaire, notée FI.

Un problème connu des mélangeurs est la génération de nombreux produits de mélanges, encore appelés produits d'intermodulation. Ces signaux parasites sont les produits aux fréquences +/-mRF +/-nOL, avec {n, m} des entiers naturels. Notamment, le problème s'accentue lorsque les spectres de l'oscillateur et/ou du signal entrant sont très larges. Dans ce dernier cas de nombreux signaux parasites se retrouvent dans la bande utile ou proches de la bande utile en sortie du mélangeur.

Une solution connue est d'éliminer en sortie du mélangeur les produits de mélanges parasites par un dispositif de filtrage adéquat. Cette solution présente l'avantage de filtrer efficacement les signaux parasites autour du signal utile mais présente l'inconvénient majeur de ne pouvoir traiter les signaux parasites dans la bande utile ou proches de la bande utile.

Une autre solution consiste à choisir des architectures de mélangeurs hétérodynes conçues pour éliminer certains signaux parasites par construction.

Parmi ces architectures, il existe des mélangeurs simplement équilibrés qui résultent de l'association de deux mélangeurs simples à l'aide de diviseurs et de combineurs sur les accès RF et/ou OL et/ou FI. L'utilisation de tels mélangeurs permet de réduire de moitié le nombre de raies parasites dans la bande utile.

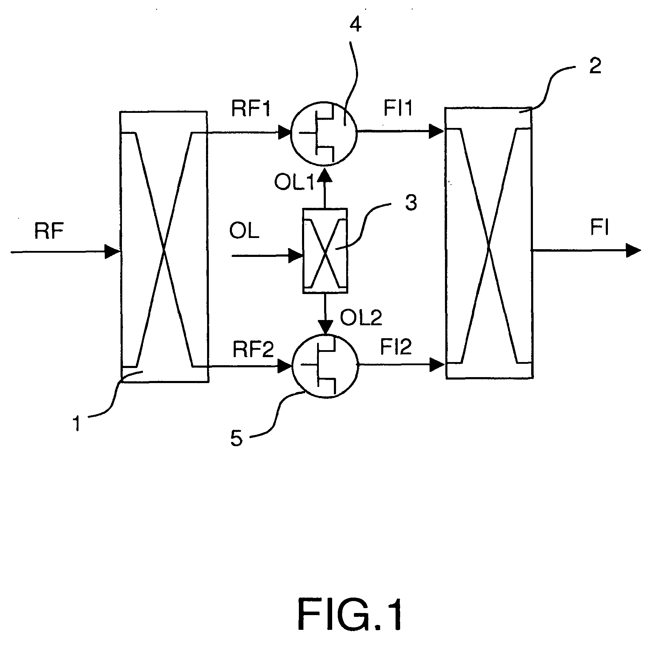

La figure 1 représente un tel mélangeur simplement équilibré. Le mélangeur comporte un premier diviseur 1 permettant de diviser un signal RF entrant en deux signaux RF1 et RF2 équilibrés en amplitude, les phases de RF1 et RF2 pouvant être différentes. Un second diviseur 3 permet de diviser le signal OL, en deux signaux OL1, OL2 de même amplitude et dont les phases peuvent être différentes.

Deux mélangeurs 4, 5 mélangent respectivement d'une part le signal RF1 et le signal OL1 en un premier signal utile FI1 et d'autre part le signal RF2 et le signal OL2 en un second signal utile FI2.

Les signaux FI1 et FI2 sont de même amplitude et même spectre. Ils peuvent, en revanche, comporter un déphasage entre eux selon les déphasages de OL1 et OL2 d'une part et de RF1 et RF2 d'autre part.

Un combineur 2 permet de combiner les signaux FI1 et FI2 en un signal de sortie FI utile. Selon la valeur du déphasage de FI1 et FI2, il est usuel d'établir un coupleur de Wilkinson pour un déphasage entre FI1 et FI2 de 0°, un coupleur de Lange ou encore appelé dans la terminologie anglo-saxonne « branch-line » pour un déphasage de 90° et un coupleur de Marchand pour un déphasage de 180°.

Par combinaison, le principe d'une telle architecture permet de réduire certaines raies parasites par construction du signal FI. Certains signaux parasites s'annulent simplement par sommation comportant un déphasage par exemple de 180°.

D'autres architectures plus complexes permettent de supprimer un plus grand nombre de raies par construction. Par exemple, parmi elles, il y a des mélangeurs doublement équilibrés ou des mélangeurs triplement équilibrés.

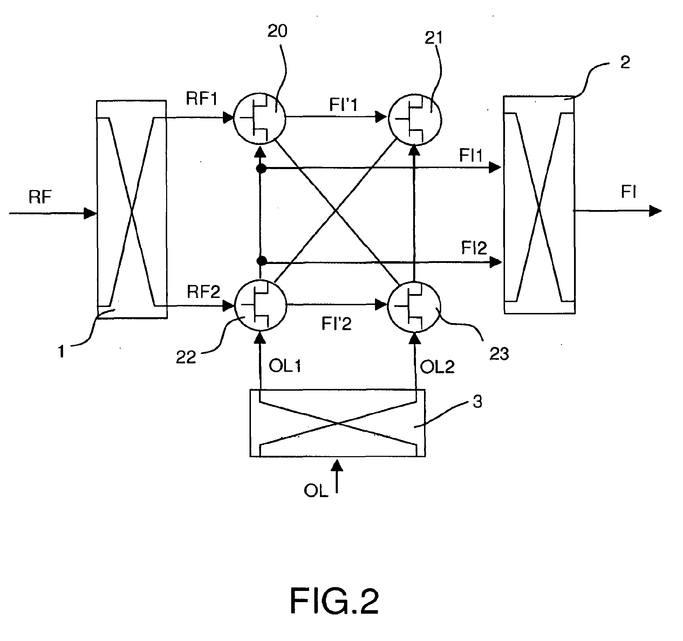

La figure 2 représente un exemple d'une architecture d'un mélangeur doublement équilibré comportant un diviseur 1 du signal RF. Le diviseur 1 permet l'obtention de deux signaux RF1 et RF2 équilibrés en amplitude dont les phases peuvent être différentes selon le déphasage introduit par le diviseur.

Un diviseur 3 permet, comme précédemment, de diviser le signal issu de l'oscillateur local afin d'obtenir deux signaux OL1, OL2 équilibrés en amplitude. Quatre mélangeurs 20, 21, 22 et 23 permettent de mélanger les signaux RF1, RF2 avec les signaux OL1 et OL2 afin d'obtenir les signaux FI1 et FI2. Les signaux FI1, FI2 sont alors recombinés dans un combineur 2 afin d'obtenir un signal de sortie FI.

Cette solution, plus complexe que le mélangeur simplement équilibré, permet par le biais de déphasages entre les signaux OL1 et OL2 et entre les signaux RF1 et RF2 et enfin entre les signaux FI1 et FI2 de supprimer en partie les signaux parasites lors de la combinaison dans le combineur de sortie (2).

Cette solution présente un avantage de pouvoir supprimer des signaux parasites dans la bande utile ou proches de la bande utile par une simple combinaison des signaux selon leur déphasage.

En revanche, cette solution présente un inconvénient majeur. En effet, les produits d'intermodulation dépendent du signal entrant, notamment de sa fréquence et de la bande utile. En conséquence, les raies parasites aux fréquences +/-mRF +/-nOL obligent à choisir, dès la conception, des déphasages pour les diviseurs et les combineurs adéquates. Généralement le choix des déphasages des différents éléments diviseurs et combineur permettent de supprimer les raies parasites les plus gênantes pour une application donnée, c'est à dire pour un signal entrant RF donné.

Un inconvénient est donc l'absence de flexibilité d'une telle architecture contrainte d'être conçue pour un signal d'entrée spécifique et notamment en fonction de sa fréquence. Les applications de tels mélangeurs sont donc le plus souvent dédiées et ne présentent pas une modularité suffisante pour s'adapter à un nouveau signal d'entrée ou à une nouvelle application, sauf à modifier les composants.

Par ailleurs, une telle solution est coûteuse en conception puisqu'il faut développer autant de mélangeurs que d'applications.

L'invention permet de résoudre les inconvénients précités.

A cet effet l'invention permet de disposer de déphaseurs programmables soit directement dans les diviseurs et/ou dans le combineur, soit en entrée ou en sortie des diviseurs et/ou du combineur d'un mélangeur hétérodyne.

Le principe de la suppression des signaux parasites dans une mélangeur, en utilisant un seul déphaseur variable dans une des voies des signaux, est déjà connu, par example dans les publications des brevets US 6 137 999, et US 2006/0035617.

Cette solution permet d'ajuster le déphasage entre les signaux divisés et combinés à partir d'une commande électrique selon le type d'application utilisée.

Avantageusement, le mélangeur hétérodyne comprend :

- Un premier moyen de division (1) équilibré en amplitude d'un signal d'entrée (RF) permettant de générer un premier signal (RF1) et un second signal (RF2) ;
- Un second moyen de division (3) équilibré en amplitude permettant de diviser un signal référence (OL) en un premier signal référence (OL1) et en un second signal référence (OL2) ;
- Au moins deux cellules de mélanges (4, 5) équilibrées en amplitude mélangeant d'une part le premier signal (RF1) avec le premier signal référence (OL1) de manière à créer un premier signal intermédiaire (FI1) et d'autre part le second signal (RF2) avec le second signal référence (OL2) de manière à créer un second signal intermédiaire (FI2);
- Un moyen de combinaison (2) permettant de re-combiner le premier signal intermédiaire (FI1) et le second signal intermédiaire (FI2) en un signal de sortie intermédiaire (FI).

Avantageusement, au moins un dispositif de déphasage configurable permet de déphaser un signal d'une phase réglable par l'intermédiaire d'une télécommande, le déphaseur configurable étant positionné dans l'un quelconque des moyens de division ou de combinaison du mélangeur, la phase réglable étant choisie de telle manière qu'un ensemble de produits de mélange indésirables entre les signaux d'entrée divisés (RF1, RF2) et les signaux de référence divisés (OL1, OL2) soient sommés en opposition de phase dans les moyens de combinaison (2).

Avantageusement, deux déphaseurs configurables, étant chacun ajustés au moyen d'une télécommande, sont positionnés dans chacun des moyens de division respectivement du signal d'entrée (RF) et du signal de référence (OL).

Avantageusement, dans un autre mode de réalisation deux déphaseurs configurables, étant chacun ajustés au moyen d'une télécommande, sont positionnés dans chacun des moyens de division respectivement du signal d'entrée (RF) et du signal intermédiaire (FI).

Avantageusement, dans un autre mode de réalisation deux déphaseurs configurables, étant chacun ajustés au moyen d'une télécommande, sont positionnés dans chacun des moyens de division respectivement du signal de référence (OL) et du signal intermédiaire (FI).

Avantageusement, dans un autre mode de réalisation deux déphaseurs configurables, étant chacun ajustés au moyen d'une télécommande, sont positionnés dans chacun des moyens de division respectivement du signal d'entrée (RF), du signal de référence (OL) et du signal intermédiaire (FI).

Avantageusement, dans un autre mode de réalisation trois déphaseurs configurables, étant chacun ajustés au moyen d'une télécommande, sont positionnés en sortie de chacun des moyens de division respectivement du signal RF et du signal FI2 et à l'entrée des moyens de combinaison.

Avantageusement, l'ensemble des produits de mélange indésirables sont choisis parmi un ensemble d'entiers {n, m} vérifiant la relation suivante : FI = +/-mRF +/-nOL, où OL est la fréquence du signal de référence et RF la fréquence du signal d'entrée du mélangeur hétérodyne.

Avantageusement, la télécommande pilote une commande électrique commandant une tension en N état(s), N étant un entier naturel positif.

Avantageusement, les phases réglables des dispositifs de déphasages configurables sont choisies parmi les phases 0°, -90°, +90° et -180°.

Avantageusement, les phases réglables des dispositifs de déphasages configurables sont choisies telles que :

$+/-n\varphi_{RF} +/-m\varphi_{OL} \in [-180°;+180°]$, où $\varphi_{RF}$ est la phase réglable du dispositif de déphasage configurable positionné à l'une des sorties des moyens de divisions du signal d'entrée et $\varphi_{OL}$ est la phase réglable du dispositif de déphasage configurable positionné à l'une des sorties des moyens de divisions du signal de référence.

Avantageusement, le procédé d'élimination d'un ensemble de produits d'intermodulation parasitant un signal intermédiaire (FI) obtenu à partir d'un mélangeur selon l'invention, pour des applications dans lesquelles un changement de la fréquence du signal entrant (RF) est réalisé, **caractérisé en ce qu'**il comprend :

■ une première étape de calcul de la nouvelle fréquence intermédiaire (FI);
■ une seconde étape du calcul des produits d'intermodulation induisant une perturbation sur le signal intermédiaire (FI), consistant à trouver les entiers n et m tel que :

$$FI = +/-mRF +/-nOL$$

soit dans la bande utile ou proche de la bande utile ;
■ une troisième étape de réglage par l'intermédiaire d'au moins une télécommande d'au moins une phase réglable d'un dispositif de déphasage configurable du mélangeur de manière à obtenir un ensemble de produits d'intermodulation induisant une perturbation sur le signal intermédiaire (FI) en opposition de phase à l'entrée du moyen de combinaison.

Avantageusement, la première étape est réalisée le choix d'une fréquence intermédiaire vérifiant une relation :
$FI = |\pm mRF +nOL|$
Avantageusement, la seconde étape comprend le calcul des produits d'intermodulation pour n et m inférieur ou égal à 5 et dont l'amplitude des produits +/-mRF +/-nOL sont supérieurs à un seuil prédéterminé.
D'autres caractéristiques et avantages de l'invention apparaîtront à l'aide de la description qui suit, faite en regard des dessins annexés qui représentent :

- a figure 1 : un mélangeur simplement équilibré de l'art antérieur ;
- la figure 2: un mélangeur doublement équilibré de l'art antérieur ;
- la figure 3 : un mélangeur simplement équilibré selon l'invention.

Dans la suite de la description on appellera indifféremment un déphaseur dont la phase est pilotée par un signal de commande dynamique, quasi-statique ou statique, un « déphaseur programmable » ou un « déphaseur configurable ».
Dans la suite de la description on appellera indifféremment un signal de commande dynamique, quasi-statique ou statique, une « télécommande ».
L'invention permet dans un mélangeur hétérodyne de modifier au moins l'un des déphasages du combineur et/ou des diviseurs. Un choix approprié d'un de ces déphasages permet de supprimer une grande partie des produits d'intermodulation introduisant des perturbations dans la bande utile ou proches de la bande utile à la fréquence intermédiaire. En outre, l'invention permet de changer le déphasage de telle sorte qu'il n'est pas nécessaire de modifier ou remplacer les composants du mélangeur hétérodyne.

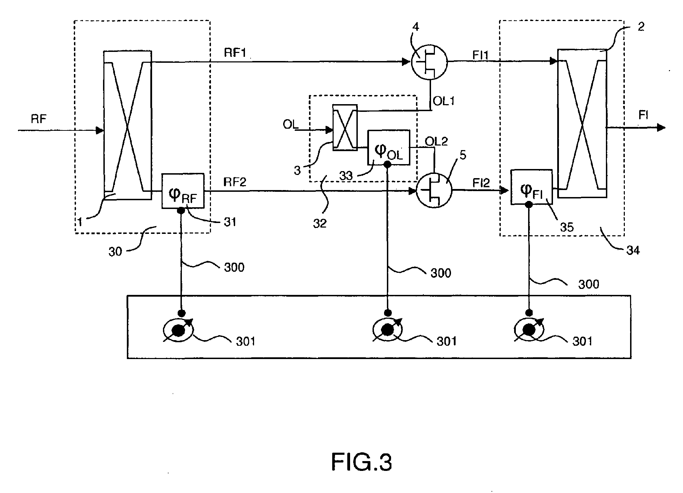

La figure 3 représente un mode de réalisation privilégié d'un mélangeur simplement équilibré comportant un module diviseur 30 comprenant un diviseur 1 et un déphaseur programmable 31, un module diviseur 32 comprenant un diviseur 3 et un déphaseur programmable 33 et enfin un module combineur 34 comprenant un combineur 2 et un déphaseur programmable 35.
Le signal entrant RF est divisé en deux signaux équilibrés en amplitude RF1 et RF2 par le diviseur 1. Le signal RF2 peut-être déphasé du signal RF1 d'une phase $\varphi_{RF}$ réglable par une télécommande 300, 301 pilotant le déphaseur programmable 31. Le déphaseur programmable 31 peut se trouver indifféremment sur les voies RF1 et/ou RF2.
La figure 3 représente respectivement trois télécommandes. Chacune des télécommandes comporte un actionneur 301 et une liaison 300 au déphaseur programmable.
L'oscillateur local OL est divisé en deux signaux OL1 et OL2 équilibrés en amplitude par le diviseur 3. Le signal OL2 peut être déphasé du signal OL1 d'une phase $\varphi_{OL}$ réglable par une seconde télécommande 300, 301 pilotant le déphaseur programmable 33. Le déphaseur programmable 33 peut se trouver indifféremment sur les voies OL1 et/ou OL2.
Les signaux RF1 et OL1 sont mélangés par un mélangeur 4 et le produit des signaux génère un signal utile FI1. De la même manière, les signaux RF2 et OL2 sont mélangés par un mélangeur 5 et le produit des signaux génère un signal utile FI2.
Enfin, les signaux FI1 et FI2 sont combinés par le combineur 2. Le déphaseur 35 permet d'ajuster la phase $\varphi_{FI}$ du signal FI2 entrant dans le combineur 2. La phase $\varphi_{FI}$ du signal FI2 est réglable par une télécommande 300, 301 pilotant le déphaseur programmable. Le déphaseur programmable 35 peut se trouver indifféremment sur les voies FI1 et/ou FI2.
Des variantes de réalisations permettent d'utiliser un seul déphaseur placé dans l'un quelconque des modules diviseur(s) ou combineur.

D'autres variantes sont obtenues en utilisant seulement deux déphaseurs programmables dans au moins deux modules diviseur(s) et/ou combineur d'un mélangeur simplement équilibré.

Il y a donc plusieurs variantes, telles que celles dont un mélangeur comprend un seul déphaseur programmable. Les trois cas suivants sont possibles :

- ■ Un déphaseur programmable dans le module diviseur 30 ;
- ■ Un déphaseur programmable dans le module diviseur 32 ;
- ■ Un déphaseur programmable dans le module combineur 34 ;

Et des mélangeurs hétérodynes comprenant au moins deux déphaseurs programmables. Les quatre cas suivants sont possibles :

- ■ Un déphaseur programmable dans le module diviseur 30 et un autre dans le module combineur 32 ;
- ■ Un déphaseur programmable dans le module diviseur 30 et un autre dans le module combineur 34 ;
- ■ Un déphaseur programmable dans le module diviseur 32 et un autre dans le module combineur 34 ;
- ■ Un déphaseur programmable dans chaque module diviseur 30 et 32 et un autre dans le module combineur 34 ;

Généralement, dans la pratique on choisira de régler un ou deux ou trois déphasage(s) parmi les trois phases $\varphi_{RF}$, $\varphi_{FI}$, $\varphi_{OL}$.

Dans un mode de réalisation, les déphasages des déphaseurs configurables seront préférentiellement choisis entre -180°, -90°, 0°, +90°, +180°, mais des valeurs intermédiaires ne sont pas exclues. Ce choix de déphasages possibles permet de calculer les combinaisons des déphasages des signaux des deux branches du mélangeur plus efficacement.

Un mode de réalisation préféré permet au combineur 34 de combiner les spectres utiles des signaux FI1 et FI2 en phase et les produits d'intermodulation parasites des signaux FI1 et FI2 en opposition de phase. La sommation en opposition de phase de signaux parasites de même fréquence et de même amplitude ayant pour effet de les éliminer dans le signal utile re-combiné en sortie du combineur.

Dans un exemple de réalisation comprenant deux déphaseurs configurables dans une des branches du mélangeur hétérodyne, il est possible d'ajuster deux déphasages par l'intermédiaire de la télécommande. Ainsi, pour un mélangeur hétérodyne comprenant un déphaseur configurable 31 dans le diviseur 1 et un déphaseur configurable 33 dans le diviseur 3, il est possible d'ajuster les déphasages $\varphi_{RF}$ et $\varphi_{OL}$ dans l'une des branches du mélangeurs hétérodynes.

Les déphasages $\varphi_{RF}$ et $\varphi_{OL}$ sont alors choisis de manière à supprimer les produits d'intermodulation indésirables proches ou sensiblement égaux à la fréquence du signal utile FI.

En théorie, il existe une infinité de doublets d'entiers naturels {m ;n} permettant d'obtenir : FI = +/-mRF +/-nOL, dans l'exemple de réalisation.

En pratique, les produits d'intermodulation qui parasitent le signal utile sont obtenus pour des faibles multiples des fréquences des signaux RF et d'OL. Généralement, l'amplitude des signaux est d'autant plus élevé que les valeurs de n et m sont assez faibles.

Pour un signal RF divisé en deux signaux RF1 et RF2 de même amplitude et même fréquence et un oscillateur local OL se divisant en deux signaux OL1 et OL2 de même amplitude et même fréquence, les mélangeurs génèrent, dans chacune des branches du mélangeur hétérodyne, les mêmes produits parasites de signaux de type {+/-mRF1 +/-nOL1} et {+/-mRF2 +/-nOL2}, où {n, m} sont des entiers naturels.

Les produits FI1 et FI2 utiles dans chaque branche du mélangeur hétérodyne sont obtenus généralement pour une combinaison de type RF1-OL1 ou RF1+OL1 et RF2-OL2 ou RF2+OL2. Néanmoins, il peut s'agir d'une autre combinaison choisie pour générer une fréquence intermédiaire utile FI. Par exemple un autre cas aurait pu être FI = 20L-RF. Cela dépend de l'application et de l'architecture choisie pour le mélangeur.

Les diviseurs permettent d'obtenir des signaux intermédiaires FI1 et FI2 de même amplitude et de spectre similaire.

Les produits d'intermodulation les plus gênants pour le traitement du signal FI sont obtenus pour des valeurs de n et m telles que +/-mRF +/-nOL est sensiblement égale ou très proche de la fréquence FI utile.

Les déphasages $\varphi_{RF}$ et $\varphi_{OL}$ introduits à partir d'une télécommande dans l'une des branches du mélangeur hétérodyne permettent d'introduire un déphasage entre les signaux FI1 et FI2.

Dans un exemple de réalisation, le déphasage $\Phi = +/- n\varphi_{RF} +/m\varphi_{OL}$ du signal FI2 peut être ajusté de manière à ce qu'il soit sensiblement proche de +/-180° pour les signaux parasites {m ;n} dans la bande utile ou proches de la bande utile.

Ce choix permet en outre de sommer en opposition de phase dans le combineur les signaux indésirables préalablement divisés et mélangés et ayant la même fréquence et la même amplitude.

Dans ce dernier cas, un déphasage $\Phi$ introduit dans l'une des branches du mélangeur hétérodyne de 180° permet de sommer des signaux perturbateurs dans le combinateur de manière à ce qu'ils s'annulent.

Généralement, les produits d'intermodulation introduisant de fortes perturbations sur le signal utile sont des multiples des signaux OL et RF pour des nombres entiers n et m inférieurs à 10. Il y a donc lieu d'examiner les différentes combinaisons possibles pour les différentes valeurs de n et m telles que :

$$+/\text{-}n\varphi_{RF} \; +/\text{-}m\varphi_{OL} \; = \; +/\text{-}180°$$

pour les produits parasites {m ;n} indésirables dans la bande intermédiaire FI

Selon les valeurs des signaux RF et OL, il est possible de choisir des valeurs de $\varphi_{RF}$ et de $\varphi_{OL}$ de manière à obtenir un déphasage $\Phi$ égal à +/-180° pour un maximum de produits d'intermodulation parasites.

Un intérêt d'une telle solution, lorsque la fréquence RF est amenée à être changée au cours d'une mission, réside dans la grande flexibilité du re-calcul des produits d'intermodulation parasites et de l'ajustement des déphaseurs configurables pour adapter les déphasages par le biais d'une télécommande.

Dans un exemple de réalisation d'un mélangeur simplement équilibré selon l'invention, un cas de figure peut être obtenu pour les valeurs suivantes :

■ Signal entrant: RF = 30 GHz ;
■ Oscillateur local : OL = 10 GHz ;
■ Fréquence intermédiaire portant le signal utile: FI = 20 GHz ;

Selon les mesures effectuées, trois produits d'intermodulation induisent des perturbations significatives dans la bande utile :

■ 5OL-RF = 20 GHz ;
■ 2RF-4OL = 20GHz ;
■ 2OL = 20GHz ;

Pour un choix de $\varphi_{RF}$ = 90°, $\varphi_{FI}$ = 0° et $\varphi_{OL}$ = 90°, on obtient la suppression des produits 2RF-4OL ($2x\varphi_{RF}$ - $4x\varphi_{OL}$ + $\varphi_{FI}$ = 180°) ainsi que 2OL ($2x\varphi_{OL}$ + $\varphi_{FI}$ = 180°).

Un avantage d'une telle solution est de pouvoir ajuster les phases $\varphi_{RF}$, $\varphi_{FI}$, $\varphi_{OL}$ pour différentes applications nécessitant de traiter différents signaux reçus RF entrants dans le mélangeur. Si une application nécessite de décaler le signal RF en fréquence, le déphasage d'une des branches du mélangeur hétérodyne peut être adapté à partir d'une télécommande.

Une simple reconfiguration des phases d'au moins un déphaseur programmable permet d'ajuster les signaux FI1 et FI2 de telle manière que les produits introduisant des perturbations puissent se retrouver en opposition de phase dans le combineur.

Dans un autre mode de réalisation, les déphaseurs peuvent être directement intégrés au diviseur ou au combineur, c'est à dire dans le composant même.

Dans des variantes de réalisations, la télécommande peut être une commande électrique commandant une tension en n états, n étant un entier naturel positif.

Dans des variantes de réalisation, la télécommande peut piloter un déphaseur programmable par voie hertzienne. Dans ce dernier cas, il est possible de reconfigurer au moins un déphaseur programmable dans des applications embarquées telles que des satellites pour des changements de missions.

Enfin, une variante de réalisation permet de pré-positionner par câblage sur une tension fixe des déphaseurs configurables dans un mélangeur doublement équilibré dans au moins un des diviseurs ou combineur du mélangeur tel que celui représenté figure 2.

Un avantage d'une telle solution est de pouvoir s'affranchir en conception d'architectures complexes de mélangeurs hétérodynes comportant une large bande assurant une loi de suppression de produits de mélange.

Un autre avantage est de pouvoir reconfigurer de façon dynamique un mélangeur qui traite un signal d'entrée RF large bande avec un oscillateur local variable. Cette solution permet de supprimer des produits de mélange selon la valeur de l'oscillateur local.

**Revendications**

1. Mélangeur hétérodyne comprenant :

■ un premier moyen de division (1) équilibré en amplitude d'un signal d'entrée (RF) permettant de générer un premier signal (RF1) et un second signal (RF2) ;

■ un second moyen de division (3) équilibré en amplitude permettant de diviser un signal référence (OL) en un premier signal référence (OL1) et en un second signal référence (OL2) ;

■ au moins deux cellules de mélanges (4, 5) équilibrées en amplitude mélangeant d'une part le premier signal (RF1) avec le premier signal référence (OL1) de manière à créer un premier signal intermédiaire (FI1) et d'autre part le second signal (RF2) avec le second signal référence (OL2) de manière à créer un second signal intermédiaire (FI2) ;

■ un moyen de combinaison (2) permettant de re-combiner le premier signal intermédiaire (FI1) et le second signal intermédiaire (FI2) en un signal de sortie intermédiaire (FI),

**caractérisé en ce qu'**au moins deux dispositifs de déphasage configurables, au moyen d'une télécommande, permettent de régler la phase respectivement desdits premier (RF1) et second (RF2) signaux, lesdits au moins deux dispositifs de déphasage configurables étant positionnés de la façon suivante :

■ un premier dispositif de déphasage configurable est positionné :

a. dans lesdits premiers moyens de division (1) ; ou :
b. dans lesdits seconds moyens de division (3) ;

■ un second dispositif de déphasage configurable est respectivement positionné :

a. dans lesdits seconds moyens de division (3) ou dans lesdits moyens de combinaison (2) du signal de sortie intermédiaire (FI) ; ou :
b. dans lesdits premiers moyens de division (1) ou dans lesdits moyens de combinaison (2) du signal de sortie intermédiaire (FI),

chaque phase desdits premier (RF1) et second (RF2) signaux étant choisie de telle manière qu'un ensemble de produits de mélange indésirables produit dans lesdites cellules de mélange (4, 5) entre les signaux d'entrée divisés (RF1, RF2) et les signaux de référence divisés (OL1, OL2) soient sommés en opposition de phase dans les moyens de combinaison (2)

**2.** Mélangeur hétérodyne selon la revendication 1, **caractérisé en ce que** deux déphaseurs configurables, étant chacun ajustés au moyen d'une télécommande, sont positionnés dans chacun des moyens de division respectivement du signal d'entrée (RF) et du signal de référence (OL).

**3.** Mélangeur hétérodyne selon la revendication 1, **caractérisé en ce qu'**un premier déphaseur configurable est positionné dans les moyens de division du signal d'entrée (RF) et qu'un second déphaseur configurable est positionné dans les moyens de combinaison du signal intermédiaire (FI).

**4.** Mélangeur hétérodyne selon la revendication 1, **caractérisé en ce qu'**un premier déphaseur configurable est positionné dans les moyens de division du signal de référence (OL) et qu'un second déphaseur configurable est positionné les moyens de combinaison du signal intermédiaire (FI).

**5.** Mélangeur hétérodyne selon la revendication 1, **caractérisé en ce que** trois déphaseurs configurables, étant chacun ajusté au moyen d'une télécommande, sont positionnés en sortie de chacun des moyens de division respectivement du signal RF et du signal FI2 et à l'entrée des moyens de combinaison des signaux FI.

**6.** Mélangeur hétérodyne selon l'une quelconque des revendications 1 à 5, **caractérisé en ce que** l'ensemble des produits de mélange indésirables sont choisis parmi un ensemble des entiers {n, m} vérifiant la relation suivante : FI = +/-mRF +/-nOL, où OL est la fréquence du signal de référence et RF la fréquence du signal d'entrée du mélangeur hétérodyne.

**7.** Mélangeur hétérodyne selon la revendication 1, **caractérisé en ce que** la télécommande pilote une commande électrique commandant une tension en N état(s), N étant un entier naturel positif.

**8.** Mélangeur hétérodyne selon l'une quelconque des revendications 2 à 5, **caractérisé en ce que** les phases réglables des dispositifs de déphasages configurables sont choisies parmi les phases 0°, -90°, +90 ° et -180 °.

9. Mélangeur hétérodyne selon la revendication 6, **caractérisé en ce que** les phases réglables des dispositifs de déphasages configurables sont choisies telles que :

+/-n$\varphi_{RF}$ +/-m$\varphi_{OL}$ ∈ [-180°;+180°], où $\varphi_{RF}$ est la phase réglable du dispositif de déphasage configurable positionné à l'une des sorties des moyens de divisions du signal d'entrée (RF) et $\varphi_{OL}$ est la phase réglable du dispositif de déphasage configurable positionné à l'une des sorties des moyens de divisions du signal de référence (OL).

10. Procédé d'élimination d'un ensemble de produits d'intermodulation parasitant un signal intermédiaire (FI) obtenu à partir d'un mélangeur de l'une quelconque des revendications 3 à 9, pour des applications dans lesquelles un changement de la fréquence du signal entrant (RF) est réalisé, **caractérisé en ce qu'**il comprend :

■ Une première étape de calcul de la nouvelle fréquence intermédiaire (FI) ;
■ Une seconde étape du calcul des produits d'intermodulation induisant une perturbation sur le signal intermédiaire (FI), consistant à trouver les entiers n et m tel que :

FI = +/-mRF +/-nOL soit dans la bande utile ou proche de la bande utile ;

■ Une troisième étape de réglage par l'intermédiaire d'au moins une télécommande d'au moins une phase réglable d'un dispositif de déphasage configurable du mélangeur de manière à obtenir un ensemble de produits d'intermodulation en opposition de phase à l'entrée du moyen de combinaison.

11. Procédé d'élimination d'un ensemble de produits d'intermodulation parasitant un signal intermédiaire (FI) selon la revendication 10, **caractérisé en ce que** la première étape est réalisée le choix d'une fréquence intermédiaire vérifiant une relation : FI = |±mRF ±nOL|

12. Procédé d'élimination d'un ensemble de produits d'intermodulation parasitant un signal intermédiaire (FI) selon la revendication 10, **caractérisé en ce que** la seconde étape comprend le calcul des produits d'intermodulation dont l'amplitude des produits +/-mRF +/nOL sont supérieurs à un seuil prédéterminé.

**Patentansprüche**

1. Heterodynmischer, der Folgendes umfasst:

■ ein erstes amplitudenausgeglichenes Mittel (1) zum Teilen eines Eingangssignals (RF), so dass ein erstes Signal (RF1) und ein zweites Signal (RF2) erzeugt werden können;
■ ein zweites amplitudenausgeglichenes Mittel (3) zum Teilen eines Referenzsignals (OL) in ein erstes Referenzsignal (OL1) und ein zweites Referenzsignal (OL2);
■ wenigstens zwei amplitudenausgeglichene Mischzellen (4, 5), die einerseits das erste Signal (RF1) mit dem ersten Referenzsignal (OL1) mischen, um ein erstes Zwischensignal (FI1) zu erzeugen, und andererseits das zweite Signal (RF2) mit dem zweiten Referenzsignal (OL2) mischen, um ein zweites Zwischensignal (FI2) zu erzeugen;
■ ein Kombinationsmittel (2), mit dem das erste Zwischensignal (FI1) und das zweite Zwischensignal (FI2) zu einem Zwischenausgangssignal (FI) kombiniert werden können,

**dadurch gekennzeichnet, dass** es wenigstens zwei konfigurierbare Phasenverschiebungsvorrichtungen zulassen, die Phase jeweils des ersten (RF1) und des zweiten (RF2) Signals mittels einer Fernsteuerung zu regeln, wobei die wenigstens zwei konfigurierbaren Phasenverschiebungsvorrichtungen wie folgt positioniert sind:

■ eine erste konfigurierbare Phasenverschiebungsvorrichtung:

a) in den ersten Teilungsmitteln (1); oder
b) in den zweiten Teilungsmitteln (3) positioniert ist;

■ eine zweite konfigurierbare Phasenverschiebungsvorrichtung jeweils:

a) in den zweiten Teilungsmitteln (3) oder in den Mitteln (2) zum Kombinieren des Zwischenausgangssignals (FI); oder

b) in den ersten Teilungsmitteln (1) oder in den Mitteln (2) zum Kombinieren des Zwischenausgangssignals (FI) positioniert ist,

wobei jede Phase des ersten (RF1) und zweiten (RF2) Signals so gewählt wird, dass ein Satz von in den Mischzellen (4, 5) zwischen den geteilten Eingangssignalen (RF1, RF2) und den geteilten Referenzsignalen (OL1, OL2) erzeugten unerwünschten Mischprodukten in Phasenopposition in den Kombinationsmitteln (2) summiert wird.

2. Heterodynmischer nach Anspruch 1, **dadurch gekennzeichnet, dass** zwei konfigurierbare Phasenschieber, die jeweils mit einer Fernsteuerung justiert werden, in jedem der Teilungsmittel des Eingangssignals (RF) bzw. des Referenzsignals (OL) positioniert sind.

3. Heterodynmischer nach Anspruch 1, **dadurch gekennzeichnet, dass** ein erster konfigurierbarer Phasenschieber in den Teilungsmitteln des Eingangssignals (RF) positioniert ist und ein zweiter konfigurierbarer Phasenschieber in den Mitteln zum Kombinieren des Zwischensignals (FI) positioniert ist.

4. Heterodynmischer nach Anspruch 1, **dadurch gekennzeichnet, dass** ein erster konfigurierbarer Phasenschieber in den Mitteln zum Teilen des Referenzsignals (OL) positioniert ist und ein zweiter konfigurierbarer Phasenschieber in den Mitteln zum Kombinieren des Zwischensignals (FI) positioniert ist.

5. Heterodynmischer nach Anspruch 1, **dadurch gekennzeichnet, dass** drei konfigurierbare Phasenschieber, die jeweils mit einer Fernsteuerung justiert werden, am Ausgang jedes der Teilungsmittel des Signals RF bzw. des Signals FI2 und am Eingang der Mittel zum Kombinieren der Signale FI positioniert sind.

6. Heterodynmischer nach einem der Ansprüche 1 bis 5, **dadurch gekennzeichnet, dass** der Satz von unerwünschten Mischprodukten aus einem Satz von ganzen Zahlen {n, m} ausgewählt ist, die die folgende Beziehung erfüllen: FI = +/- mRF +/- nOL, wobei OL die Frequenz des Referenzsignals ist und RF die Frequenz des Eingangssignals des Heterodynmischers ist.

7. Heterodynmischer nach Anspruch 1, **dadurch gekennzeichnet, dass** die Fernsteuerung einen elektrischen Befehl steuert, der eine Spannung in N Zuständen regelt, wobei N eine positive natürliche ganze Zahl ist.

8. Heterodynmischer nach einem der Ansprüche 2 bis 5, **dadurch gekennzeichnet, dass** die regelbaren Phasen der konfigurierbaren Phasenverschiebungsvorrichtungen aus den folgenden Phasen ausgewählt werden: 0°, -90°, +90° und -180°.

9. Heterodynmischer nach Anspruch 6, **dadurch gekennzeichnet, dass** die regelbaren Phasen der konfigurierbaren Phasenverschiebungsvorrichtungen so gewählt werden, dass:

$+/- n\varphi_{RF} +/- m\varphi_{OL} \in$ [-180°; +180°], wobei $\varphi_{RF}$ die regelbare Phase der konfigurierbaren Phasenverschiebungsvorrichtung ist, die an einem der Ausgänge der Mittel zum Teilen des Eingangssignals (RF) positioniert ist, und $\varphi_{OL}$ die regelbare Phase der konfigurierbaren Phasenverschiebungsvorrichtung ist, die an einem der Ausgänge der Mittel zum Teilen des Referenzsignals (OL) positioniert ist.

10. Verfahren zum Eliminieren eines Satzes von Intermodulationsprodukten, die ein Zwischensignal (FI) stören, das von einem Mischer nach einem der Ansprüche 3 bis 9 erhalten wird, für Anwendungen, bei denen eine Änderung der Frequenz des eingehenden Signals (RF) realisiert wird, **dadurch gekennzeichnet, dass** es Folgendes beinhaltet:

■ einen ersten Schritt des Berechnens der neuen Zwischenfrequenz (FI);
■ einen zweiten Schritt des Berechnens von Intermodulationsprodukten, die eine Störung auf das Zwischensignal (FI) verursachen, der das Finden von ganzen Zahlen n und m beinhaltet, so dass:

FI = +/-mRF +/-nOL entweder im nützlichen Band oder nahe dem nützlichen Band ist;

■ einen dritten Schritt des Regelns, mittels wenigstens einer Fernsteuerung, von wenigstens einer regelbaren Phase einer konfigurierbaren Phasenverschiebungsvorrichtung des Mischers, um einen Satz von Intermodulationsprodukten in Phasenopposition am Eingang der Kombinationsmittel zu erhalten.

11. Verfahren zum Eliminieren eines Satzes von Intermodulationsprodukten, die ein Zwischensignal (FI) nach Anspruch 10 stören, **dadurch gekennzeichnet, dass** der erste Schritt das Auswählen einer Zwischenfrequenz beinhaltet, die die folgende Beziehung erfüllt: FI = |±mRF ±nOL|.

12. Verfahren zum Eliminieren eines Satzes von Intermodulationsprodukten, die ein Zwischensignal (FI) nach Anspruch 10 stören, **dadurch gekennzeichnet, dass** der zweite Schritt die Berechnung von Intermodulationsprodukten beinhaltet, für die die Amplitude der +/-mRF +/-nOL Produkte größer als eine vorbestimmte Schwelle ist.

**Claims**

1. A heterodyne mixer comprising:

   ■ a first amplitude-balanced means (1) for splitting an input signal (RF) so as to generate a first signal (RF1) and a second signal (RF2);
   ■ a second amplitude-balanced means (3) for splitting a reference signal (OL) into a first reference signal (OL1) and a second reference signal (OL2);
   ■ at least two amplitude-balanced mixing cells (4, 5) mixing, on the one hand, said first signal (RF1) with said first reference signal (OL1) so as to create a first intermediate signal (FI1) and, on the other hand, said second signal (RF2) with said second reference signal (OL2) so as to create a second intermediate signal (FI2);
   ■ a combining means (2) for combining said first intermediate signal (FI1) and said second intermediate signal (FI2) into an intermediate output signal (FI),

   **characterised in that** at least two configurable phase-shifting devices allow the phase of said first (RF1) and second (RF2) signals, respectively, to be controlled, by means of a remote control unit, with said at least two configurable phase-shifting devices being positioned as follows:

   ■ a first configurable phase-shifting device, which is positioned:

       a) in said first splitting means (1); or
       b) in said second splitting means (3);

   ■ a second configurable phase-shifting device, which is respectively positioned:

       a) in said second splitting means (3) or in said means (2) for combining said intermediate output signal (FI); or
       b) in said first splitting means (1) or in said means (2) for combining said intermediate output signal (FI),

   with each phase of said first (RF1) and second (RF2) signals being selected so that a set of unwanted mixing products produced in said mixing cells (4, 5) between said split input signals (RF1, RF2) and said split reference signals (OL1, OL2) is totalled in phase opposition in said combining means (2).

2. The heterodyne mixer according to claim 1, **characterised in that** two configurable phase-shifters, each being adjusted by means of a remote control unit, are positioned in each of said means for splitting said input signal (RF) and said reference signal (OL), respectively.

3. The heterodyne mixer according to claim 1, **characterised in that** a first configurable phase-shifter is positioned in said means for splitting said input signal (RF) and **in that** a second configurable phase-shifter is positioned in said means for combining said intermediate signal (FI).

4. The heterodyne mixer according to claim 1, **characterised in that** a first configurable phase-shifter is positioned in said means for splitting said reference signal (OL) and **in that** a second configurable phase-shifter is positioned in said means for combining said intermediate signal (FI).

5. The heterodyne mixer according to claim 1, **characterised in that** three configurable phase-shifters, each being adjusted by means of a remote control unit, are positioned at the output of each of said means for splitting said signal RF and said signal FI2, respectively, and at the input of said means for combining said signals FI.

6. The heterodyne mixer according to any one of claims 1 to 5, **characterised in that** the set of unwanted mixing products is selected from among a set of integers {n, m} verifying the following relation: FI = +/-mRF +/-nOL, where OL is the frequency of the reference signal and RF is the frequency of the input signal of the heterodyne mixer.

7. The heterodyne mixer according to claim 1, **characterised in that** the remote control unit controls an electrical command controlling a voltage in N state(s), with N being a positive natural integer.

8. The heterodyne mixer according to any one of claims 2 to 5, **characterised in that** the adjustable phases of the configurable phase-shifting devices are selected from among the following phases: 0°, -90°, +90° and -180°.

9. The heterodyne mixer according to claim 6, **characterised in that** the adjustable phases of the configurable phase-shifting devices are selected such that:

   +/-n$\varphi_{RF}$ +/-m$\varphi_{OL} \in$ [-180°; +180°], where $\varphi_{RF}$ is the adjustable phase of the configurable phase-shifting device positioned at one of the outputs of said means for splitting said input signal (RF) and $\varphi_{POL}$ is the adjustable phase of the configurable phase-shifting device positioned at one of the outputs of said means for splitting said reference signal (OL).

10. A method for eliminating a set of intermodulation products interfering with an intermediate signal (FI) obtained from a mixer according to any one of claims 3 to 9, for applications in which a change in the frequency of the incoming signal (RF) is realised, **characterised in that** it comprises:

    ■ a first step of calculating the new intermediate frequency (FI);
    ■ a second step of calculating intermodulation products causing a perturbation on said intermediate signal (FI), comprising finding the integers n and m such that:

       FI = +/-mRF +/-nOL either in the useful band or close to the useful band;

    ■ a third step of adjusting, by means of at least one remote control unit, at least one adjustable phase of a configurable phase-shifting device of the mixer so as to obtain a set of intermodulation products in phase opposition at the input of said combining means.

11. The method for eliminating a set of intermodulation products interfering with an intermediate signal (FI) according to claim 10, **characterised in that** said first step involves selecting an intermediate frequency verifying the following relation: FI = $|\pm mRF \pm nOL|$.

12. The method for eliminating a set of intermodulation products interfering with an intermediate signal (FI) according to claim 10, **characterised in that** said second step comprises the calculation of intermodulation products, for which the amplitude of the +/mRF +/-nOL products is greater than a predetermined threshold.

FIG.1

# FIG.2

FIG.3

**EP 2 175 554 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6137999 A

- US 20060035617 A